# EUROPEAN PATENT SPECIFICATION

(11) **EP 2 661 457 B1**
(45) Date of publication and mention of the grant of the patent: **28.03.2018**
(21) Application number: 11810600.4
(22) Date of filing: 23.12.2011
(51) Int. Cl.: C08J 5/06, D21H 13/26, H05K 1/03, H01B 3/52

(54) **ELECTRICAL INSULATING PAPER**
ELEKTRISCH ISOLIERENDES PAPIER
PAPIER ISOLANT ÉLECTRIQUE

(30) Priority: 04.01.2011 EP 11150107
(43) Date of publication of application: 13.11.2013
(60) Divisional application: 18156731.4
(73) Proprietor: Teijin Aramid B.V., 6824 BM Arnhem (NL)
(72) Inventor: ROLINK, Ben Gerhardus Antonius, NL-7339 EC Ugchelen (NL); VISSER, Richard, NL-8011 NZ Zwolle (NL); DIEDERING, Frank, NL-7411 JB Deventer (NL)
(74) Representative: Heimann, Anette
(86) International application number: PCT/EP2011/073970
(87) International publication number: WO 2012/093048

(56) References cited:
- WO-A1-2004/031466
- WO-A1-2005/103376
- JP-A- 2007 308 836
- JP-A- 2010 114 173
- JP-A- 2010 239 062
- US-A- 5 026 456
- US-A1- 2007 087 178
- US-A1- 2009 162 605

## Description

The invention pertains to electrical insulating paper, to an insulated conductor comprising said paper, to a transformer, generator or electric motor comprising said insulated conductor, and to a method of preparing said paper.

Aramid papers are known in the art.
WO2005/103376 describes an aramid paper which is suitable for composite structures and which is made using a combination of para-aramid pulp, floc, and optionally a polymer binder material.
WO2004/031466 describes a laminate of aramid nonwoven sheet and polyester resin having an overall thickness of 5 to 25 mils (0.13 to 6.4 mm) and having an elongation at break of at least 40% in both the cross and machine direction and an average tear load in excess of 1.5 pounds-force (6.7 newtons) in both the cross and machine directions.
US2009/0162605 describes papers made with floc containing a polymer or copolymer derived from a monomer selected from the group consisting of 4,4'diaminodiphenyl sulfone, 3,3'diaminodiphenyl sulfone, and mixtures thereof. Such papers allegedly have higher elongation-at-break and work-to-break (toughness) properties and exhibit less shrinkage at high temperatures than papers made with solely with poly (metaphenylene isophthalamide) floc.

Electrical insulating paper comprising meta-aramid fibrid is known in the art.

In JP 2006200066 an electrical insulating aromatic polyamide fiber paper has been described. The aromatic polyamide fiber paper contains a copoly-para-phenylene-3,4'-oxydiphenylene-terephthalamide (Technora®) staple fiber and a heat-resistant organic polymer as main components.

In JP 10130496 a sheet has been described which is suitable as an insulating material for use in electronic equipment and appliances, by compounding meta-aramid fibrid, aramid flock, mica particles and thermally conductive inorganic particles Poly(meta-phenylene isophthalamide) is preferred as the aramid.

In JP 7032549 an aramid layered product is formed by laminating and integrating an aramid paper consisting of meta-aramid fibrid and a heat resistant short fiber, and a polyethylene terephthalate film by pressurizing and heat bonding.

In EP 930393 an electrical insulating paper composed mainly of an aramid short fiber and a fibrid consisting of an organic high molecular polymer, including Technora®, has been described wherein the fibrid is partially softened and/or melted to allow the fibrid to act as a binder. This reference also discloses in examples 8 and 10 a fiber sheet comprising copoly-para-phenylene-3,4'-oxydiphenylene-terephthalamide or PPTA staple fiber and what has been called "fibrids consisting of a polyparaphenylene terephthamide". However, it is clear that what has been called "fibrid" in these examples must be pulp. This is directly derivable from the equilibrium water content 5.4%, which is a typical value for PPTA pulp, whereas PPTA fibrid has an equilibrium water content 80-90%. Finally, at the date of filing PPTA fibrid was unknown. The first report of PPTA fibrid dates from 30 June 2005, (WO 2005/059247), 8 years after the priority date of this reference, wherein a new method was used to enable for the first time the production of para-aramid fibrid. This reference only discloses the use of 90% aramid staple fiber and 10% para-aramid pulp (erroneously called fibrid).

In US 2006266486 an electroconductive aramid paper suitable for electrostatic discharge interference and/or electromagnetic interference shielding was described. These papers contain meta-aramid fibrid and conductive filler. Such papers, because they are conducting are unsuitable for electrical insulation paper.

In US 5126012 a high strength fibrid-floc sheet was made of a floc which can be carbon, aramid or glass. The sheets contain meta-aramid fibrids. Some of these papers have electrical properties.

US 5026456 relates to calandered paper comprising aramid fibrid. The paper has not been disclosed to be electrical insulating. Moreover, this paper has not been described to contain para-aramid fibrid, which was unknown at that time of filing (1990) and was not published earlier than in 2006 in WO 2005/059247, but only meta-aramid fibrid, i.e. poly(meta-phenylene isophthalamide), as is clear from the experimental disclosure of this reference. This is also clear from the fact that this reference refers to aramid paper pulp prepared from dried paper containing floc and fibrids as described in U.S. Pat. Nos. 2,999,788 and 3,756,908, which both only disclose meta-aramid fibrid.

Para-aramid papers are also known, but usually these do not contain para-aramid fibrid. In JP 8074195 a high-performance para-type aramid paper has been described, comprising impregnation of the paper made of para-type aromatic polyamide selected from pulp, short fiber and staple fiber with a binder consisting of a polar amide solvent solution containing an alkali metal or alkaline earth metal chloride. The obtained para-aramid paper is useful as an electrical insulating paper.

In WO 2008/122374 and WO 2005/059247 papers have been described comprising para-aramid fibrid. These papers contain high amounts of para-aramid fibrid, 50 and 100% respectively. These papers were not obtained by a calendering process and the papers thus obtained are not described as being electrical insulating. It was not disclosed either that these papers could be used in conductors and/or transformers. Uncalendered para-aramid containing papers have been found unsuitable in applications where electrical insulation is of importance (see experimental part).

Other references relating to paper are WO 2005/103376, US 2009/162605, and WO 2004/031466, each of which only disclosing papers containing meta-aramid fibrid.

In the market for electrical insulation there is a desire for improvement of the known Nomex® (meta-aramid) insulating papers. It was now found that para-aramid paper based on para-aramid fibrid is an alternative to Nomex®. It was further shown that such paper shows improvement with regard to its electrical insulation and its thermal conductivity properties in comparison with Nomex® paper, and has improved dimensional stability at increased temperatures above 300 °C.

The invention pertains to electrical insulating paper comprising 80 -100% by weight of para-aramid fibrid. It is well possible, and in many instances preferred to use 100% by weight of para-aramid fibrid.
The term "para-aramid" means an aramid having at least 95%, more preferably exclusively (i.e. 100%), para bonds between the aromatic moieties. Copolymers having also other than para bonds, such as copolyparaphenylene/3, 4'-oxydiphenylene terephthalamide (Technora®) which contains for about 33% meta bonds, are not contained in the definition of 80-100 % by weight of para-aramid fibrid. Preferably the fibrid is poly(para-phenylene terephthalamide) (PPTA) fibrid.

If the paper contains less than 100% by weight of fibrid, other constituents, such as aramid particles including aramid pulp, aramid floc, aramid staple fiber, aramid fibril, meta-aramid fibrid, meta-/para-aramid fibrid, can also be used in the paper. If not yet 100%, the balance can be made from other common papermaking components, such as fillers including mica, graphite, clay such as kaolin and bentonite, nanotubes, thermal conductive fillers such as aluminum nitride, aluminum oxide, boron nitride, magnesium oxide and zinc oxide, minerals, binders, fibers, tackifiers, adhesives, and the like. The paper can be free from glass fiber. The para-aramid fibrid paper of this invention thus can contain other aramid particles, preferably other para-aramid particles such as PPTA particles, meta-aramid fibrid, meta-/para-particles (such as Technora®), additives as commonly used in the papermaking process, and combinations thereof. Kaolin is a preferred additive. It is further preferred to introduce kaolin into the fibrid during the spinning process, for instance as has been described in WO 2008/122374.

The paper of this invention has a bulk density of at least 0.7 g/cm³, preferably 0.9 g/cm³ or higher. Papers with bulk densities less than 0.7 g/cm³ were found to have low dielectrical strength.

Fibrids are small, non-granular, non-rigid fibrous or film-like particles. The film-like fibrid particles have two of their three dimensions in the order of microns, and have one dimension less than 1 micron. Their smallness and suppleness allows them to be deposited in physically entwined configurations such as are commonly found in papers made from wood pulp. Meta-aramid fibrids may be prepared by shear precipitation of polymer solutions into coagulating liquids as is well known from U.S. Pat. No. 2,999,788. In this invention only fibrids of the film-like type (also called filmy fibrids) are used.
Fibrids of wholly aromatic polyamides (aramids) are also known from U.S. Pat. No. 3,756,908, which discloses a process for preparing poly(meta-phenylene isophthalamide) (MPD-I) fibrids in column 5 lines 37-54. Before use in paper or pressboard manufacture, the fibrids can be refined to provide improved electrical properties in the products made thereof and also to provide better sheet quality on paper forming machines.

Para-aramid fibrids, as herein defined, cannot be made by these common methods and are made via a much later developed jet spin process such as described in EP 1694914.

The invention also relates to a method of making the above electrical insulating papers. It was found that for obtaining suitable insulating properties at least 80% of the paper should be para-aramid fibrid. In papermaking a dilute suspension of fibers in water is drained through a screen, so that a mat of randomly interwoven fibers is laid down. Water is removed from this mat of fibers by pressing and drying to make paper. However, it was also found that such paper only contained sufficient insulating properties if the paper after the drying step of the paper making process was calendered. It was also found that a further improvement could be obtained if the calendering was performed at elevated temperature, particularly at 100 °C or higher, preferably between 150 °C to 300 °C, more preferably between 180 and 220 °C, and most preferably between 180 and 200 °C.

The most suitable electrical conductive papers have been made from para-aramid film-like particles with Schopper-Riegler (SR) values between 60 and 85, preferably between 70 and 80, whereas their specific surface area (SSA) should preferably less than 10 m²/g, more preferably between 0.5 and 10 m²/g, most preferably between 1 and 4 m²/g.

The term "thermal conductive filler" relates to thermally conductive insulator materials, which are thermally conductive electrically insulating materials that are designed for a wide variety of applications which be required high performance of heat transfer and electrical isolation, to resist cut through in screw mounting applications, these products provide a more consistent breakdown voltage over other insulation constructions. These materials are commonly applied in electrical power generators, switching mode power suppliers and signal amplifiers. Examples of such materials can be found in US 4,869,954, and include aluminum nitride, aluminum oxide, boron nitride, magnesium oxide and zinc oxide.

The term "electrical insulated paper" relates to paper having an electric resistance of at least 10¹³ Ωcm according to the volume resistivity method of ASTM D-257. Preferably, the resistance is at least 10¹⁵ Ωcm.

It may be beneficial for the electrical properties of the paper to subject the fibrid to shear forces, such as in a Waring blender, prior to using it in the papermaking process. It is highly recommended to use para-aramid only, although minor amounts of Nomex® can also be used. The para-aramid is preferably poly(para-phenylene terephthalamide) (=PPTA).

It is common practice in the manufacture of insulated electrical windings, such as those used in electrical motors or in power transformers, to insulate the respective turns of the windings from one another by placing insulating sheet material between the winding turns. Such sheet material insulation is normally only required on high voltage windings or windings having relatively large turns which inherently develop relatively high voltages between the adjacent turns of the winding. The present papers are suitable for insulating conductors and for making transformers.

### EXPERIMENTAL

### Papermaking process (general procedure)

All paper recipes have been made on the Rapid Koethe (RK) handsheet former according to the method of ISO 5269-2. Drying was done using the RK-dryer under vacuum at 95 °C. Calendering of the dried papers was done at 10 µm gap control at 200 °C. For calendering two steel rollers were used.

The dielectric strength measurements were done at the Technical University of Delft (Netherlands) according to ASTM D149 97A 920040. The thickness of the papers was measured according to TAPPI 411 om-05 at the position of the dielectric breakdown. This thickness was used in the calculation of the dielectric strength. At least 5 breakdowns for each type of paper were measured to give the average dielectric strength (which is denoted in the Table).

Thermal conductivity was measured according to ASTM C 1114-98.

### Examples

Paper was made according to the method of ISO 5269-2 and thereafter calendered according to the general procedure, unless indicated differently. The ingredients for making paper amounted to 1.6 g of material (based on dry weight), resulting in sheets of 50 g/m². The mixture of PPTA fibrid and kaolin was blended in a Waring blender prior to use in the procedure of ISO 5269-2.

**Results**

| Entry | Paper | dielectric strength (kV/mm) | thickness (micrometer) |
|---|---|---|---|
| 1 | 100% PPTA fibrid | 37.1 | 52 |
| 2 | 60% PPTA fibrid + 40% kaolin (Twaron® D8114) | 33.5 | 44 |
| 3 | 40% PPTA fibrid + 60% kaolin (Twaron® D8116) | 28.0 | 41 |
| 4 | 85% Twaron® D8114 + 15% short cut PPTA fiber | 27.7 | 40 |
| 5 | 70% Twaron® D8114 + 30% short cut PPTA fiber | 27.0 | 42 |
| 6 | 50% PPTA fibrid + 50% short cut PPTA fiber | 22.7 | 54 |
| 7 | 20% PPTA fibrid + 30% short cut PPTA fiber + 50% PPTA pulp (comparison) | 19.6 | 54 |
| 8 | 50% meta-aramid fibrid + 50% short cut meta-aramid fiber (Nomex® 410 (2 mil)) (comparison) | 15.8 | 57 |
| 9 | 100% PPTA pulp (comparison) | 17.3 | 54 |
| 10 | 100% meta-aramid fibrid (comparison) | 14.8 | 70 |
| 11 | 100% PPTA fibrid not calandered | 9.1 | 136 |

| | | | |
|---|---|---|---|
| PPTA fibrid: Twaron® D8016, ex Teijin Aramid, The Netherlands 60% PPTA fibrid + 40% kaolin: Twaron® D8114, ex Teijin Aramid, The Netherlands 40% PPTA fibrid + 60% kaolin: Twaron® D8116, ex Teijin Aramid, The Netherlands Short cut PPTA fiber: Twaron® T1000, 6 mm, ex Teijin Aramid, The Netherlands PPTA pulp: Twaron® 1094, ex Teijin Aramid, The Netherlands | | | |

The meta-aramid fibrid was made from poly(meta-phenylene isophthalamide) as described in U.S. Pat. No. 3,756,908.

### Heat conductivity

An experiment was performed to measure the heat conductivity (measured according to ASTM C 1114-98) wherein para-aramid fibrid paper was compared with Nomex 410 (meta-aramid fibrid) paper.:

| Paper | Thickness* (µm) | Density (g/cm³) | Thermal conductivity (mW/mK |
|---|---|---|---|
| 50% meta-aramid fibrid + 50% short cut meta-aramid fiber (Nomex 410®) | 776 | 1.1 | 161 |
| 50% para-aramid fibrid + 50% short cut para-aramid fiber | 518 | 1.1 | 205 |

| | | | |
|---|---|---|---|
| *Thermal conductivity is independent on the thickness of the paper. | | | |

## Claims

1. A method of making an electrical insulating paper with a bulk density of at least 0.7 g/cm³, comprising 80-100 % by weight of aramid film-like fibrid particles, wherein the paper as obtained on a paper-making apparatus after drying is calendered, **characterized in that** the aramid film-like fibrid particles are para-aramid film-like fibrid particles wherein the para-aramid has at least 95% para bonds between the aromatic moieties.

2. The method according to claim 1 **characterized in that** the calendering is performed at 100 °C or higher.

3. The method according to claim 2 **characterized in that** the calendering is performed between 150 °C to 300 °C.

4. The method according to claim 3 **characterized in that** the calendering is performed between 180 °C and 200 °C.

5. The method according to any one of claims 1-4 **characterized in that** the fibrid particles have a Schopper-Riegler (SR) value between 60 and 85, preferably between 70 and 80.

6. The method according to any one of claims 1-5 **characterized in that** the fibrid particles have a specific surface areas (SSA) less than 10 m²/g.

7. An electrical insulating paper comprising 80 -100 % by weight of aramid film-like fibrid particles, **characterized in that** the aramid film-like fibrid particles are para-aramid film-like fibrid particles wherein the para-aramid has at least 95% para bonds between the aromatic moieties, as obtained by the method according to any one of claims 1-6.

8. The electrical insulating paper of claim 7 **characterized in that** it comprises further at least one of aramid pulp, aramid floc, aramid staple fiber, aramid fibril, meta-aramid fibrid, meta-/para-aramid fibrid, fillers, thermal conductive fillers, and optionally common paper additives.

9. The paper of claim 8, **characterized in that** the aramid pulp, aramid floc, aramid staple fiber, and aramid fibril is para-aramid pulp, floc, staple fiber or fibril.

10. The paper of claim 8, **characterized in that** the para-aramid is poly(para-phenylene terephthalamide).

11. The paper of any one of claims 7 to 10, **characterized in that** the para-aramid film-like fibrid particles are poly(para-phenylene terephthalamide) fibrid particles.

12. An insulated conductor **characterized in that** it comprises the paper of any one of claims 7-11.

13. A transformer, generator or electric motor **characterized in that** it comprises the insulated conductor of claim 12.

## Patentansprüche

1. Verfahren zur Herstellung eines Elektroisolierpapiers mit einer Rohdichte von mindestens 0,7 g/cm³, das 80-100 Gew.-% an aramidfolienartigen Fibridteilchen umfasst, wobei das mit einer Papierherstellungsvorrichtung hergestellte Papier nach dem Trocknen kalandriert wird, **dadurch gekennzeichnet, dass** die aramidfolienartigen Fibridteilchen para-aramidfolienartige Fibridteilchen sind, wobei das Para-Aramid mindestens 95 % para-Bindungen zwischen den aromatischen Gruppen aufweist.

2. Verfahren nach Anspruch 1, **dadurch gekennzeichnet, dass** das Kalandrieren bei 100 °C oder höher durchgeführt wird.

3. Verfahren nach Anspruch 2, **dadurch gekennzeichnet, dass** das Kalandrieren bei 150 °C bis 300 °C durchgeführt wird.

4. Verfahren nach Anspruch 3, **dadurch gekennzeichnet, dass** das Kalandrieren bei 180 °C bis 200 °C durchgeführt wird.

5. Verfahren nach einem der Ansprüche 1-4, **dadurch gekennzeichnet, dass** die Fibridteilchen einen Schopper-Riegler-Wert (SR) zwischen 60 und 85, bevorzugt zwischen 70 und 80 aufweisen.

6. Verfahren nach einem der vorhergehenden Ansprüche 1-5, **dadurch gekennzeichnet, dass** die Fibridteilchen eine spezifische Oberfläche (SSA) von weniger als 10 m²/g aufweisen.

7. Elektroisolierpapier, das 80-100 Gew.-% an aramidfolienartigen Fibridteilchen umfasst, **dadurch gekennzeichnet, dass** die aramidfolienartigen Fibridteilchen para-aramidfolienartige Fibridteilchen sind, wobei das Para-Aramid mindestens 95 % para-Bindungen zwischen den aromatischen Gruppen aufweist, wie erhalten nach dem Verfahren nach einem der Ansprüche 1-6.

8. Elektroisolierpapier nach Anspruch 7, **dadurch gekennzeichnet, dass** es ferner mindestens eines von Folgenden umfasst: Aramidpulpe, Aramidflocken, Aramidstapelfaser, Aramidfibrille, Meta-Aramidfibrid, Meta-/Para-Aramidfibrid, Füllmittel, wärmeleitfähige Füllmittel und optional gängige Papierzusatzstoffe.

9. Papier nach Anspruch 8, **dadurch gekennzeichnet, dass** es sich bei Aramidpulpe, Aramidflocken, Aramidstapelfaser und Aramidfibrille um Para-Aramid-Pulpe, -Flocken, -Stapfelfaser oder -Fibrillen handelt.

10. Papier nach Anspruch 8, **dadurch gekennzeichnet, dass** es sich bei dem Para-Aramid um Polyparaphenylenterephtalamid handelt.

11. Papier nach einem der Ansprüche 7 bis 10, **dadurch gekennzeichnet, dass** es sich bei den para-aramidfolienartigen Fibridteilchen um Polyparaphenylenterephtalamid-Fibridteilchen handelt.

12. Isolierter Leiter, **dadurch gekennzeichnet, dass** er das Papier nach einem der Ansprüche 7-11 umfasst.

13. Tranformator, Generator oder elektrischer Motor, **dadurch gekennzeichnet, dass** er den isolierten Leiter aus Anspruch 12 umfasst.

## Revendications

1. Procédé de fabrication d'un papier isolant électrique présentant une masse volumique apparente d'au moins 0,7 g/cm³ et comprenant de 80 à 100 % en poids de particules fibrides pelliculaires d'aramide, dans lequel le papier obtenu sur un appareil de fabrication de papier après séchage est calandré, **caractérisé en ce que** les particules fibrides pelliculaires d'aramide sont des particules fibrides pelliculaires d'un para-aramide qui comporte au moins 95 % de liaisons para entre les motifs aromatiques.

2. Procédé conforme à la revendication 1, **caractérisé en ce que** le calandrage est opéré à une température de 100 °C ou plus.

3. Procédé conforme à la revendication 2, **caractérisé en ce que** le calandrage est opéré à une température de 150 à 300 °C.

4. Procédé conforme à la revendication 3, **caractérisé en ce que** le calandrage est opéré à une température de 180 à 200 °C.

5. Procédé conforme à l'une des revendications 1 à 4, **caractérisé en ce que** les particules fibrides présentent un indice Schopper-Riegler (SR) valant de 60 à 85, et de préférence de 70 à 80.

6. Procédé conforme à l'une des revendications 1 à 5, **caractérisé en ce que** les particules fibrides présentent une aire spécifique (SSA) inférieure à 10 m²/g.

7. Papier isolant électrique comprenant de 80 à 100 % en poids de particules fibrides pelliculaires d'aramide, **caractérisé en ce que** les particules fibrides pelliculaires d'aramide sont des particules fibrides pelliculaires d'un para-aramide comportant au moins 95 % de liaisons para entre les motifs aromatiques, et obtenu par un procédé conforme à l'une des revendications 1 à 6.

8. Papier isolant électrique conforme à la revendication 7, **caractérisé en ce qu'**il comprend en outre au moins de l'un des composants suivants : pâte d'aramide, floc d'aramide, fibres courtes d'aramide, fibrilles d'aramide, fibrides de méta-aramide, fibrides de méta/para-aramide, charges, charges thermo-conductrices, et en option, adjuvants courants des papiers.

9. Papier conforme à la revendication 8, **caractérisé en ce que** pâte d'aramide, floc d'aramide, fibres courtes d'aramide et fibrilles d'aramide sont de la pâte, du floc, des fibres courtes ou des fibrilles de para-aramide.

10. Papier conforme à la revendication 8, **caractérisé en ce que** le para-aramide est du poly(para-phénylène téréphtalamide).

11. Papier conforme à l'une des revendications 7 à 10, **caractérisé en ce que** les particules fibrides pelliculaires de para-aramide sont des particules fibrides de poly(para-phénylène téréphtalamide).

12. Conducteur isolé, **caractérisé en ce qu'**il comporte un papier conforme à l'une des revendications 7 à 11.

13. Transformateur, générateur ou moteur électrique, **caractérisé en ce qu'**il comprend un conducteur isolé conforme à la revendication 12.
